# EUROPÄISCHE PATENTSCHRIFT

(11) **EP 3 566 549 B1**
(45) Veröffentlichungstag und Bekanntmachung des Hinweises auf die Patenterteilung: **29.01.2020**
(21) Anmeldenummer: 17826168.1
(22) Anmeldetag: 13.12.2017
(51) Int. Cl.: H05B 37/02, G05G 1/08, G05G 13/00, H01H 19/14

(54) **LICHTSTELLPULT MIT DOPPELWELLENENCODER**
LIGHTING CONTROL CONSOLE HAVING A DUAL ROTARY ENCODER
PUPITRE D'ÉCLAIRAGE COMPRENANT UN CODEUR À DEUX ARBRES

(30) Priorität: 18.01.2017 DE 202017100249 U
(43) Veröffentlichungstag der Anmeldung: 13.11.2019
(73) Patentinhaber: MA Lighting Technology GmbH, 97297 Waldbüttelbrunn (DE)
(72) Erfinder: ADENAU, Michael, 97082 Würzburg (DE)
(74) Vertreter: advotec.
(86) Internationale Anmeldenummer: PCT/EP2017/082633
(87) Internationale Veröffentlichungsnummer: WO 2018/134000

(56) Entgegenhaltungen:
- EP-A2- 0 752 632
- EP-A2- 1 544 880
- DE-A1-102014 116 827
- US-A- 5 187 630
- US-A- 5 404 152
- US-A1- 2004 210 916
- US-A1- 2010 238 200

## Beschreibung

Die Erfindung betrifft ein Lichtstellpult mit Doppelwellenencoder nach dem Oberbegriff des Anspruchs 1.

Gattungsgemäße Lichtstellpulte dienen zur Steuerung von Beleuchtungsanlagen, wie sie beispielsweise in Theatern oder Konzertbühnen zum Einsatz kommen. Diese Beleuchtungsanlagen umfassen regelmäßig eine Vielzahl von Beleuchtungseinrichtungen, beispielsweise Bühnenscheinwerfer, wobei die Beleuchtungseinrichtungen vielfach auch noch für sich genommen zwischen einer Vielzahl von Beleuchtungszuständen, beispielsweise unterschiedlichen Farben, umgeschaltet werden können. Diese unterschiedlichen Beleuchtungszustände werden durch programmierte Parameter im Beleuchtungsprogramm des Lichtstellpults gespeichert und gesteuert. Übliche Beleuchtungsanlagen können dabei bis zu mehreren tausend Beleuchtungseinrichtungen umfassen. Um derart komplexe Beleuchtungsanlagen steuern zu können, sind die gattungsgemäßen Lichtstellpulte mit einem Digitalprozessor ausgestattet, der eine digitale Daten- und Signalverarbeitung erlaubt. Zur Speicherung der Daten ist weiter ein Digitalspeicher vorgesehen, der es insbesondere ermöglicht, Beleuchtungsprogramme zu archivieren.

Zur Programmierung des Beleuchtungsprogramms bzw. zur Steuerung des Beleuchtungsprogramms während seines Ablaufs müssen vom Bediener Bedienbefehle als Eingabewerte eingegeben werden. Dabei kann es sich beispielsweise um die Auswahl einer bestimmten Beleuchtungseinrichtung bzw. um die Einstellung eines bestimmten Parameters handeln. Für die Eingabe dieser Bedienbefehle sind an bekannten Lichtstellpulten mechanische Bedienelemente, beispielsweise Taster, Drehregler oder Schieberegler, vorhanden. Die den einzelnen Bedienelementen zugeordneten Bedienbefehle können dabei durch geeignete Menüumschaltung verändert werden, um entsprechend komplexe Beleuchtungsprogramme programmieren und steuern zu können.

Bei Doppelwellenencodern handelt es sich um Eingabevorrichtungen, an denen ein Benutzer durch Verdrehen eines Betätigungselements ein zugeordnetes elektrisches Signal eingeben kann. Doppelwellenencoder sind dabei dadurch charakterisiert, dass diese nicht nur ein Betätigungselement, beispielsweise einen Drehknopf oder eine Drehscheibe aufweisen, sondern zwei. Beide Betätigungselemente sind mit einer drehbar gelagerten Welle verbunden. Beiden Wellen ist jeweils ein Drehsignalgeber zugeordnet, der das Verdrehen der Welle unmittelbar oder mittelbar detektieren kann. Die beiden Drehsignalgeber erzeugen dann jeweils nach Detektion einer Stellbewegung an der Welle ein zugeordnetes elektrisches Signal.

Bei bekannten Doppelwellenencodern sind die Bedienelemente drehknopfartig ausgebildet, so dass zur Eingabe eines Parameters am Doppelwellenencoder der entsprechende Drehknopf zwischen Daumen und Zeigefinger verstellt werden muss. Dies bedeutet also mit anderen Worten, dass bei bekannten Doppelwellenencodern die Eingabe eines neuen Wertes das Verdrehen des zugeordneten Drehknopfs am Doppelwellenencoder zwischen Daumen und Zeigefinger erfordert.

Nachteilig an diesen Doppelwellenencodern mit Drehknopf ist es, dass der Bedienkomfort für den Bediener relativ gering ist. Außerdem ist es nicht möglich, an beiden Betätigungselementen des Doppelwellenencoders gleichzeitig neue Werte durch Verdrehen der Betätigungselemente einzugeben, da die entsprechende Bedienhand nur einen Daumen umfasst.

Aus der DE 10 2014 116827 A1 ist ein Lichtstellpult mit einem Doppelwellenencoder bekannt. Zur Verstellung des Doppelwellenencoders ist eine Drehscheibe und ein darüber liegend angeordneter Drehring vorgesehen. Aufgrund des unterschiedlichen Höhenniveaus von Drehscheibe und Drehring ist der Bedienkomfort des Benutzers bei Nutzung des Doppelwellenencoders eingeschränkt.

Ausgehend von diesem Stand der Technik ist es deshalb Aufgabe der vorliegenden Erfindung, ein neues Lichtstellpult mit Doppelwellenencoder vorzuschlagen, dessen Betätigungselemente, an denen der Doppelwellenencoder verstellt wird, einen höheren Bedienkomfort ermöglichen.

Vorteilhafte Ausführungsformen der Erfindung sind Gegenstand der Unteransprüche.

Das erfindungsgemäße Lichtstellpult ist im Bedienfeld mit zumindest einem Doppelwellenencoder zur Eingabe von Eingabewerten ausgestattet. Die Erfindung beruht zunächst auf dem Grundgedanken, dass die Betätigungselemente zur handbetätigten Verstellung der beiden Wellen des Doppelwellenencoders in der Art einer Drehscheibe oder eines Drehrings ausgebildet sind. Durch den Ersatz der üblichen Drehknöpfe an Doppelwellenencodern sowie durch den erfindungsgemäßen Einsatz von Drehscheiben oder Drehringen wird der Bedienkomfort bei der Eingabe von Eingabeparametern erheblich erhöht. Denn aufgrund der größeren Hebeverhältnisse erlaubt eine Drehscheibe bzw. ein Drehring das Verdrehen der Welle des Doppelwellenencoders durch Betätigung mit allein einem Finger. Das Umgreifen des Drehknopfs, wie er bei den bekannten Doppelwellenencodern notwendig ist, entfällt auf diese Weise. Im Ergebnis hat der Bediener somit die Möglichkeit, durch Berührung der beiden Drehscheiben bzw. der beiden Drehringe des erfindungsgemäßen Doppelwellenencoders mit zwei getrennten Fingern gleichzeitig zwei Eingabeparameter durch entsprechendes Verstellen der beiden Drehscheiben bzw. der beiden Drehringe zu realisieren. Somit kann auch noch die Eingabegeschwindigkeit entsprechend beschleunigt werden, da zwei Eingabewerte gleichzeitig mit einer Hand an dem Doppelwellenencoder des erfindungsgemäßen Lichtstellpults eingegeben werden können.

Um den Bedienkomfort bei der Eingabe von Eingabeparametern am Doppelwellenencoder des Lichtstellpults weiter zu erhöhen, ist es erfindungsgemäß vorgesehen, dass die Oberseite der Drehscheibe oder des Drehrings in der Art einer Fingerkuppen-Kontaktfläche ausgebildet ist. Dadurch wird ermöglicht, dass die Drehscheibe oder der Drehring durch Eingriff einer Fingerkuppe an der Fingerkuppen-Kontaktfläche rotatorisch angetrieben werden kann.

Um einen verbesserten Griffkontakt zwischen der Fingerkuppen-Kontaktfläche und der zum Eingriff vorgesehenen Fingerkuppe zu ermöglichen, ist es weiterhin erfindungsgemäß vorgesehen, dass die Finger-kuppen-Kontaktfläche konkav gewölbt ist. Durch die konkave Wölbung kann sich die Fingerkuppen-Kontaktfläche zumindest abschnittsweise an die konvex geformte Außenseite der Fingerkuppe anformen, so dass aufgrund der vergrößerten Kontaktfläche ein sicherer Halt der Fingerkuppe auf der Fingerkuppen-Kontaktfläche gegeben ist.

Um den Benutzer möglichst viel Bewegungsfreiheit beim Eingriff auf der Fingerkuppen-Kontaktfläche zu geben, ist es erfindungsgemäß vorgesehen, dass die Fingerkuppen-Kontaktfläche eine kreisringförmige Gestalt aufweist. Alternativ dazu kann die Fingerkuppen-Kontaktfläche auch eine kreisförmige Gestalt aufweisen. Innerhalb der kreisringförmigen oder kreisförmigen Fingerkuppen-Kontaktfläche kann der Benutzer dann seine Fingerkuppen relativ frei positionieren und erhält jeweils einen zuverlässigen Kontakt mit der Fingerkuppen-Kontaktfläche.

Um mit zwei Fingern gleichzeitig die beiden Drehscheiben bzw. die beiden Drehringe oder die eine Drehscheibe mit dem zugeordneten Drehring des Encoders gleichzeitig verstellen zu können, ist es erfindungsgemäß vorgesehen, dass die beiden Drehscheiben oder Drehringe, mit denen die beiden Wellen des Doppelwellenencoders angetrieben werden, auf der gleichen Höhe relativ zur Außenseite des Gehäuses angeordnet sind. Durch entsprechende Annäherung der Finger von oben auf die beiden Fingerkuppen-Kontaktflächen, die somit auf gleicher Höhe verlaufen, kann dann bei sehr guter Ergonomie eine gleichzeitige Verstellung der beiden Betätigungselemente des Doppelwellenencoders realisiert werden.

Im Hinblick auf eine hohe Verschleißfestigkeit ist es vorteilhaft, wenn an der ersten Welle ein erstes Rastwerk zur Verrastung unterschiedlicher Drehlagen der ersten Welle vorgesehen ist, wobei der erste Drehsignalgeber zur Erzeugung eines ein Umschalten zwischen zwei Rastlagen anzeigenden Datensignals vorgesehen ist. Weiter ist an der zweiten Welle ein zweites Rastwerk zur Verrastung unterschiedlicher Drehlagen der zweiten Welle vorgesehen, wobei der zweite Drehsignalgeber zur Erzeugung eines ein Umschalten zwischen zwei Rastlagen anzeigenden Datensignals vorgesehen ist.

Für bestimmte Funktionen beim Einsatz des erfindungsgemäßen Lichtstellpults ist es vorteilhaft, dass nach der Einstellung zumindest einer der beiden Wellen des Doppelwellenencoders, beispielweise zur Auswahl eines X- oder Y-Wertes, der entsprechende Wert ausgewählt und vom Benutzer bestätigt werden kann. Diese Auswahl und Bestätigung eines an der Welle eingestellten Wertes kann in einfacher Weise dadurch realisiert werden, dass zumindest eine der beiden Wellen zwischen einer Ruhestellung und einer Schaltstellung in Richtung ihrer Längsachse axial gelagert ist. Dies bedeutet also, dass die Welle nicht nur drehbar sondern auch axial verstellbar gelagert ist. Um die Auswahl und Bestätigung eines eingestellten Wertes zu realisieren, wird im Gehäuse zusätzlich ein Schaltsensor vorgesehen, mit dem die Verstellung der axial verstellbaren Welle zwischen der Ruhestellung und der Schaltstellung detektiert werden kann. Hat nun der Benutzer durch Verdrehen der Welle einen bestimmten Wert eingestellt, was durch Auswertung der Signale des Drehsignalgebers elektronisch auswertbar ist, kann der Benutzer dann die axial verstellbare Welle kurz drücken und dadurch von ihrer Ruhestellung in die Schaltstellung bringen. Diese Verstellung kann dann mit dem Schaltsensor detektiert werden, so dass der an der Welle eingestellte Wert damit vom Benutzer ausgewählt und bestätigt ist und einer weiteren elektronischen Verarbeitung zugeführt werden kann.

Alternativ bzw. additiv zur Anordnung des Schaltsensors an der verstellbaren Welle des Doppelwellenencoders kann auch unmittelbar benachbart zur Drehscheibe und/oder zum Drehring ein Drucktaster angeordnet werden. Im Gehäuse ist dann diesem Drucktaster ein Schaltsensor zugeordnet, mit dem die Ruhestellung und/oder Schaltstellung des Drucktasters detektierbar ist. Mit anderen Worten kann also durch Drücken des Drucktasters ein entsprechender Wert ausgewählt bzw. bestätigt werden. Auch ist es denkbar durch Auswertung des Schaltsensors eine Umschaltung von Funktionen im Sinne einer Shift-Taste zu realisieren. Für welche Funktionen des erfindungsgemäßen Lichtstellpults der Doppelwellenencoder eingesetzt wird, ist grundsätzlich beliebig. Da der Doppelwellenencoder des erfindungsgemäßen Lichtstellpults die Eingabe von Eingabeparametern gleichzeitig mit zwei Fingern an beiden Drehscheiben bzw. Drehringen erlaubt, können bestimmte Eingabeprozeduren besonders vereinfacht werden.

In der einfachsten Bauform kann das gesamte Lichtstellpult in ein Gehäuse eingebaut sein. Alternativ dazu ist es auch denkbar, dass das Lichtstellpult zumindest zwei Gehäuse umfasst, die mit einer Datenschnittstelle miteinander verbunden werden können. Bei der Datenschnittstelle kann es sich beispielweise um eine USB-Schnittstelle handein, so dass die Daten über ein Verbindungskable zwischen den Gehäusen übertragen werden. Alternativ sind auch drahtlose Datenschnittstellen denkbar, wie zum Beispiel eine WLAN-Schnittstelle. Am ersten Gehäuse ist der Doppelwellenencoder vorgesehen. Auch die übrigen Bedienelemente, die der Programmierung des Beleuchtungsprogramms dienen, wie Drehregler, Taster etc., können in das erste Gehäuse eingebaut werden. Das zweite Gehäuse umfasst den Digitalprozessor und zumindest einen Digitalspeicher zur Erzeugung, Verwaltung und Speicherung von Stellbefehle.

Das zweite Gehäuse oder ein drittes Gehäuse, das mit dem zweiten Gehäuse mit einem Verbindungskabel verbunden wird, kann dann außerdem die Anzeigeeinrichtung umfassen, an der Grafikelemente für den Benutzer grafisch dargestellt werden.

Ist das zweite Gehäuse in der Art eines Laptops oder Personal Computers ausgebildet, so kann ein solches Standardgerät durch Koppelung mit dem ersten Gehäuse, das den Doppelwellenencoder und die übrigen Bedienelemente enthält, die der Programmierung des Beleuchtungsprogramms dienen, zur Realisation eines kompletten Lichtstellpults genutzt werden.

Gemäß einer ersten Verfahrensvariante ist es vorgesehen, dass zunächst eine Verstellung des Betätigungselements an der ersten Welle stattfindet. Danach erfolgt eine Auswertung des Datensignals am ersten Drehsignalgeber. Der so festgestellte Ausgangswert des Drehsignalgebers wird dann zur Verstellung eines an der Anzeigeeinrichtung angezeigten Cursors in horizontaler Richtung verwendet.

Anschießend erfolgen die Verstellung des Betätigungselements an der zweiten Welle und die Auswertung des Datensignals am zweiten Drehsignalgeber. Der so festgestellte Ausgangswert des zweiten Drehsignalgebers wird dann zur Verstellung des Cursors an der Anzeigeneinrichtung in vertikaler Richtung genutzt. Durch gleichzeitige Verstellung der beiden Betätigungselemente an dem Doppelwellenencoder kann also der Cursor vom Benutzer gleichzeitig in vertikaler und in horizontaler Richtung verstellt werden.

Für die horizontale bzw. vertikale Verstellung des Cursors gibt es eine Vielzahl von unterschiedlichen Anwendungsfällen am erfindungsgemäßen Lichtstellpult. Gemäß einer Verfahrensvariante ist es vorgesehen, dass die horizontale und vertikale Verstellung des Cursors benutzt werden kann, um die Spalten und Zeilen einer Tabelle oder die Spalten und Zeilen eines Auswahlmenüs zu durchfahren. Dies bedeutet also mit anderen Worten, dass durch Verstellung der beiden Betätigungselemente des Doppelwellenencoders an dem erfindungsgemäßen Lichtstellpult der Cursor nacheinander oder auch gleichzeitig durch die Spalten und Zeilen einer Tabelle oder durch die Spalten und Zeilen eines Auswahlmenüs bewegt werden kann.

Gemäß einer alternativen Verfahrensvariante ist es vorgesehen, dass das Auswertesignal des ersten Drehsignalgebers für die Grobeinstellung eines Betriebsparameters des Lichtstellpults und das Ausgangssignal des zweiten Drehsignalgebers für die Feineinstellung des zuvor grob eingestellten Betriebsparameters genutzt wird. Auf diese Weise kann der Benutzer sehr einfach und sehr schnell eine zunächst grobe Einstellung des Betriebsparameters und eine darauf folgende Feineinstellung des Betriebsparameters durch Betätigung der beiden Betätigungselemente des Doppelwellenencoders realisieren.

Wird durch das beschriebene Verfahren eine Grob- und Feineinstellung realisiert, ist es weiterhin besonders vorteilhaft, wenn durch Betätigung eines Schaltsensors eine Ultragrobeinstellung oder eine Ultrafeineinstellung des jeweiligen Betriebsparameters in Abhängigkeit der Auswertung des ersten oder zweiten Drehsignalgebers erfolgen kann. Durch Drücken beispielsweise eines Drucktasters neben dem Doppelwellenencoder kann somit eine weitere Umschaltung erfolgen, so dass der Betriebsparameter noch schneller und noch feinfühliger vom Benutzer eingegeben werden kann.

Gemäß einer weiteren Verfahrensvariante ist es vorgesehen, dass durch die Auswertung des Ausgangssignals des ersten Drehsignalgebers die Einstellung eines ersten Farblichtparameters einer Beleuchtungseinrichtung erfolgt. Danach oder gleichzeitig kann durch Auswertung des Datensignals des zweiten Drehsignalgebers die Einstellung eines zweiten Farblichtparameters der gleichen Beleuchtungseinrichtung erfolgen, so dass der Benutzer auf diese Weise beispielsweise die Lichtfarbe und/oder die Lichtintensität und/oder die Lichttemperatur einer Beleuchtungseinrichtung weitgehend gleichzeitig durch Betätigung der beiden Betätigungselemente eingeben kann.

Gemäß einer weiteren Verfahrensvariante ist es vorgesehen, dass durch Auswertung der Datensignale des ersten Drehsignalgebers die Einstellung eines ersten Bewegungsparameters einer Beleuchtungseinrichtung und dann durch Auswertung des Datensignals des zweiten Drehsignalgebers die Einstellung eines zweiten Bewegungsparameters der gleichen Beleuchtungseinrichtung erfolgen kann.

Auf diese Weise kann beispielsweise sehr einfach die Pan-Einstellung und die Tilt-Einstellung einer in zwei Bewegungsachsen verstellbar gelagerten Beleuchtungseinrichtung durch Nutzung des Doppelwellenencoders an dem erfindungsgemäßen Lichtstellpult eingegeben werden.

Gemäß einer weiteren Verfahrensvariante kann die Auswertung des Datensignals des ersten Drehsignalgebers zur Einstellung eines ersten Zeitmessparameters, beispielsweise zur Einstellung der Minuten, genutzt werden. Durch Auswertung des Datensignals am zweiten Drehsignalgeber kann dann die Einstellung eines zweiten Zeitmessparameters, beispielsweise der Sekunden, erfolgen.

Eine Ausführungsform der Erfindung ist in den Zeichnungen schematisch dargestellt und wird nachfolgend beispielhaft erläutert.

Es zeigen:
- **Fig. 1**: ein Lichtstellpult mit mehreren Doppelwellenencodern in perspektivischer Ansicht von oben;
- **Fig. 2**: das Lichtstellpult gemäß Fig. 1 in Ansicht von oben;
- **Fig. 3**: eine Elektronikplatine des Lichtstellpults gemäß Fig. 1, auf der die Doppelwellenencoder montiert sind, in perspektivischer Ansicht von oben;
- **Fig. 4**: einen Doppelwellenencoder des Lichtstellpults gemäß Fig. 1 in perspektivischer seitlicher Ansicht;
- **Fig. 5**: die beiden Betätigungselemente des Doppelwellenencoders gemäß Fig. 4 in perspektivischer Ansicht von oben;
- **Fig. 6**: die Betätigungselemente gemäß Fig. 5 in seitlicher Ansicht;
- **Fig. 7**: die Betätigungselemente gemäß Fig. 5 in Ansicht von oben;
- **Fig. 8**: die Betätigungselemente gemäß Fig. 7 im Querschnitt entlang der Schnittlinie A-A;
- **Fig. 9**: die Betätigungselemente gemäß Fig. 5 im demontierten Zustand in seitlicher Ansicht;
- **Fig. 10**: die Betätigungselemente gemäß Fig. 5 im demontierten Zustand in Ansicht von oben.

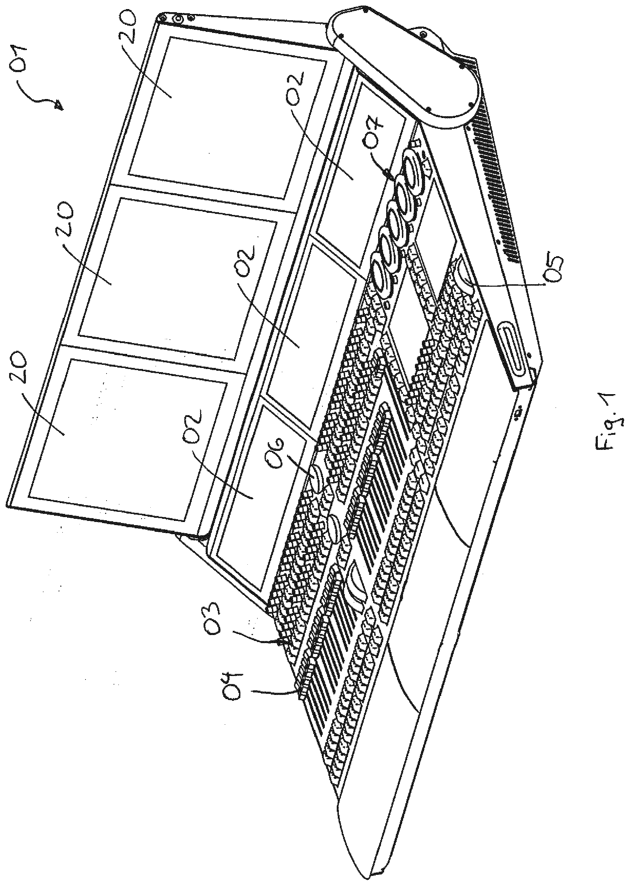

**Fig. 1** zeigt in perspektivischer Ansicht ein erfindungsgemäßes Lichtstellpult 01 zur Programmierung und Steuerung einer Bühnenbeleuchtungsanlage. Das Lichtstellpult 01 ist mit drei Monitoren 02 und drei weiteren Monitoren 20 zur Anzeige von diversen Menüs für den Benutzer ausgestattet. Zur Eingabe von Stellbefehlen sind am Lichtstellpult 01 eine Vielzahl von Druckknöpfen 03, Schieberegler 04 und Stellräder 05 vorgesehen. Außerdem sind zur Eingabe von Bedienbefehlen zwei einfache Drehwellenencoder 06 und fünf Doppelwellenencoder 07 in das Bedienfeld 08 des Lichtstellpults 01 eingebaut.

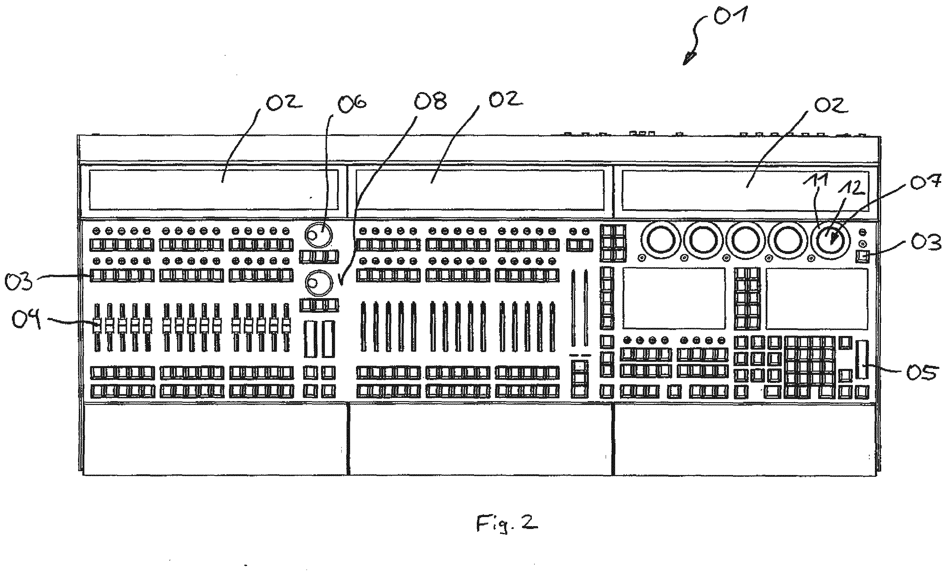

**Fig. 2** zeigt das Lichtstellpult gemäß Fig. 1 in Ansicht von oben.

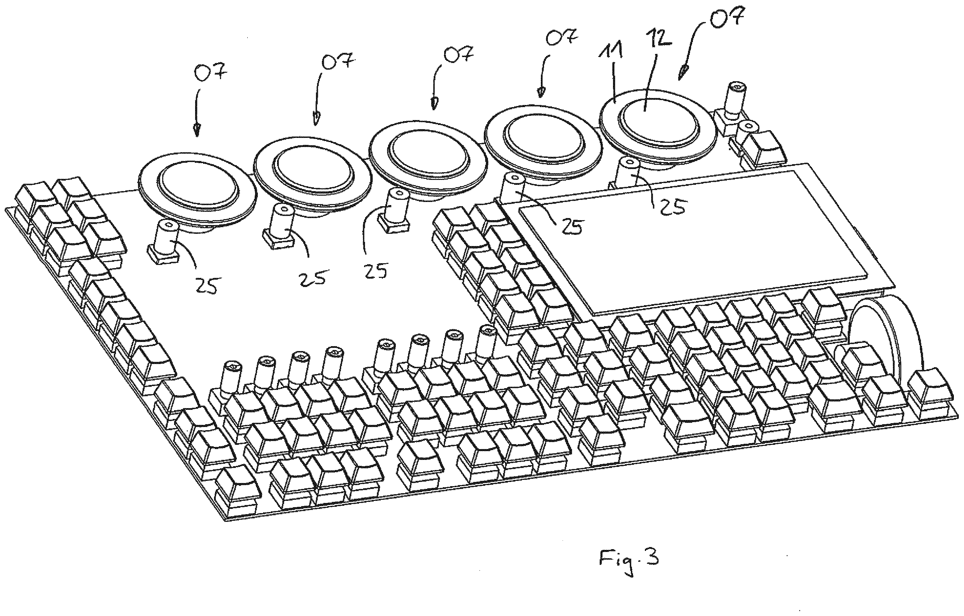

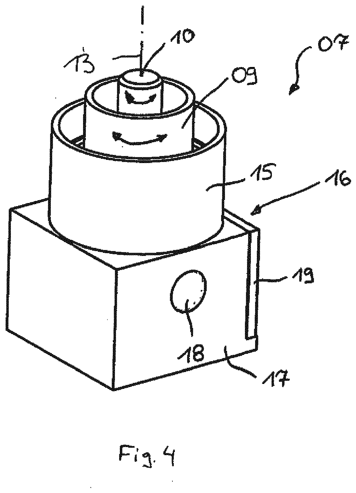

**Fig. 3** zeigt eine Elektronikplatine des Lichtstellpults 01, auf der die Doppelwellenencoder 07 montiert sind, in perspektivischer Ansicht von oben. Die in das Bedienfeld 08 des Lichtstellpults 01 eingebauten Doppelwellenencoder 07 weisen jeweils zwei drehbar gelagerte Wellen, nämlich eine Hohlwelle 09 und eine darin koaxial drehbar gelagerte Zentralwelle 10 auf (siehe Fig. 4). Am oberen Ende der Hohlwelle 09 und der Zentralwelle 10 sind zwei unabhängig voneinander verstellbare Betätigungselemente, nämlich ein Drehring 11 und eine Drehscheibe 12 befestigt. Mit dem Drehring 11 kann die Hohlwelle 09 verstellt werden. Mit der Drehscheibe 12 kann die Zentralwelle 10 verdreht werden.

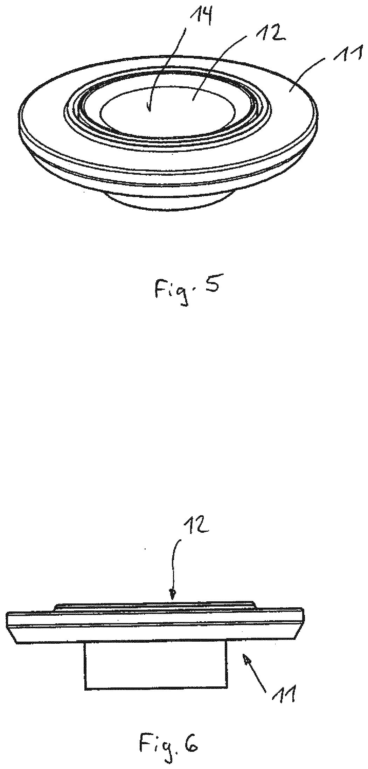

Durch Handbetätigung der Drehscheibe 12 bzw. des Drehrings 11 können also die Hohlwelle 09 und die Zentralwelle 10 rotatorisch um ihre Längsachse unabhängig voneinander verdreht werden, um dadurch Stellbefehle in das Lichtstellpult einzugeben. Die Hohlwelle 09 ist dabei zusätzlich axial in Richtung der Längsachse 12 verstellbar gelagert, so dass der Benutzer durch Druck auf die Oberseite 14 (siehe Fig. 5) der Drehscheibe 12 einen durch Verdrehen der Hohlwelle 09 eingestellten Wert auswählen und bestätigen kann. Neben jedem Doppelwellenencoder 07 ist ein Drucktaster 25 angeordnet, mit welchem die Funktionalitäten der Doppelwellenencoder 07 im Sinne eines Shift-Schalter umgeschaltet werden können.

**Fig. 4** zeigt den unteren Teil des Doppelwellenencoders 07 mit den drehbar gelagerten Wellen 09 und 10 in perspektivischer seitlicher Ansicht. Die Hohlwelle 09 ist im zylindrischen Oberteil 15 des Gehäuses 16 drehbar gelagert. Die Zentralwelle 10 ist in der Hohlwelle 09 drehbar gelagert. An das Oberteil 15 des Gehäuses 16 schließt sich ein rechteckiges Unterteil 17 an, das der Befestigung des Doppelwellenencoders 07 im Gehäuse des Lichtstellpults 01 dient.

**Fig. 5** zeigt die beiden Betätigungselemente des Doppelwellenencoders 07, nämlich den Drehring 11 und die Drehscheibe 12, in perspektivischer seitlicher Ansicht.

**Fig. 6** zeigt den Drehring 11 und die Drehscheibe 12 in seitlicher Ansicht.

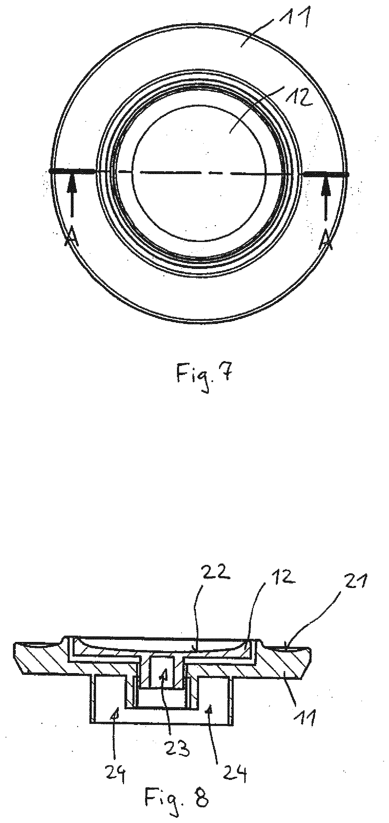

**Fig. 7** zeigt den Drehring 11 und die Drehscheibe 12 in Ansicht von oben.

**Fig. 8** zeigt den Drehring 11 und die Drehscheibe 12 im Querschnitt. An der Oberseite des Drehrings 11 und der Drehscheibe 12 sind jeweils konkav gewölbte Fingerkuppen-Kontaktflächen 21 bzw. 22 vorgesehen, an denen jeweils ein Finger des Benutzers mit der Fingerkuppe zum Eingriff kommen kann, um mit den beiden Fingern beide Betätigungselemente des Doppelwellenencoders 07 gleichzeitig verstellen zu können. Die Fingerkuppen-Kontaktfläche 21 ist dabei kreisringförmig ausgestaltet, wohingegen die Fingerkuppen-Kontaktfläche 22 kreisförmige Gestalt aufweist. Die Zentralwelle 10 wird von unten in die Ausnehmung 23 der Drehscheibe 12 eingesteckt. Die Hohlwelle 09 wird von unten in die Ausnehmung 24 des Drehrings 11 eingesteckt. Beide Fingerkuppen-Kontaktflächen 21 und 22 der beiden Betätigungselemente des Doppelwellenencoders 07 befinden sich auf der gleichen Höhe und erlauben eine ergonomische Betätigung des Doppelwellenencoders 07 mit zwei Fingern.

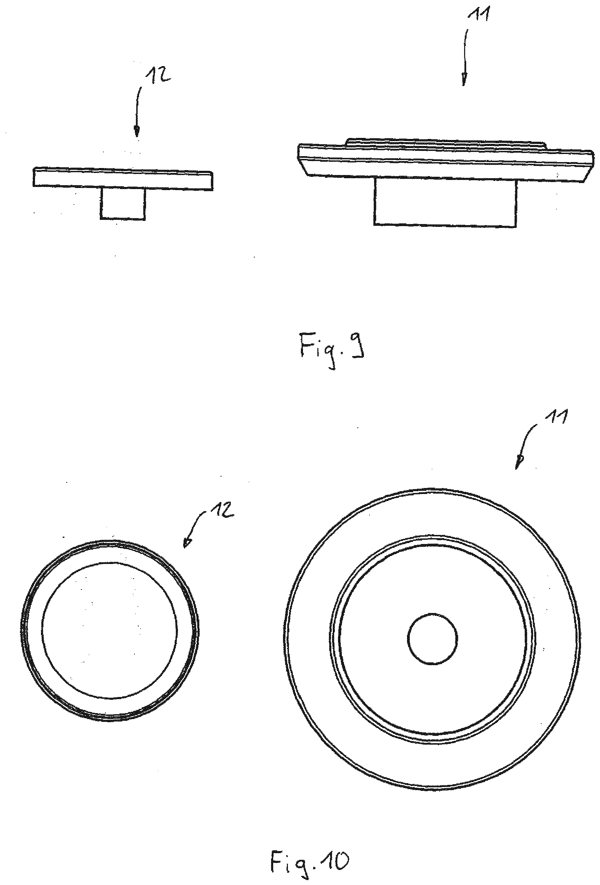

**Fig. 9** und **Fig. 10** zeigen die Drehscheibe 12 und den Drehring 11 im demontierten Zustand in seitlicher Ansicht bzw. in Ansicht von oben.

## Patentansprüche

1. Lichtstellpult (01) zur Steuerung einer Beleuchtungsanlage, wobei das Lichtstellpult (01) ein Bedienfeld (08) und zumindest eine Anzeigeeinrichtung umfasst, wobei an der Anzeigeeinrichtung Grafikelemente für den Benutzer grafisch dargestellt werden können, und wobei im Bedienfeld (08) zumindest ein Doppelwellenencoder (07) vorgesehen ist, an dem Eingabewerte von einem Benutzer eingegeben werden können, wobei der Doppelwellenencoder (07) eine erste drehbar in einem Gehäuse (16) gelagerte Welle (09) aufweist, wobei an der ersten Welle ein erster Drehsignalgeber zur Erzeugung eines Datensignals vorgesehen ist, wobei der Doppelwellenencoder (07) eine zweite, koaxial drehbar in dem Gehäuse (16) gelagerte Welle (10) aufweist, wobei an der zweiten Welle (10) ein zweiter Drehsignalgeber zur Erzeugung eines Datensignals vorgesehen ist, wobei beide Wellen (09, 10) Betätigungselemente (11, 12) aufweisen, an denen Stellbewegungen von Hand auf die Wellen (09, 10) übertragen werden können, und wobei die Betätigungselemente zur handbetätigten Verstellung der Wellen (09, 10) jeweils in der Art einer Drehscheibe (12) oder eines Drehrings (11) ausgebildet sind, welche im Bedienfeld (08) des Lichtstellpults (01) angeordnet sind und koaxial gegeneinander verdreht werden können, **dadurch gekennzeichnet, dass** jeweils die Oberseite der Drehscheibe (12) bzw. des Drehrings (11) in der Art einer Fingerkuppen-Kontaktfläche (21, 22) ausgebildet ist, wobei die jeweilige Drehscheibe (12) bzw. der jeweilige Drehring (11) durch Eingriff einer Fingerkuppe an der Fingerkuppen-Kontaktfläche (21, 22) rotatorisch antreibbar ist, wobei die Fingerkuppen-Kontaktfläche (21, 22) jeweils konkav gewölbt ist, wobei die Fingerkuppen-Kontaktfläche (21) jeweils eine kreisringförmige Gestalt oder eine kreisförmige Gestalt aufweist, wobei die erste Fingerkuppen-Kontaktfläche (22) der Drehscheibe (12) bzw. des Drehrings, mit der die erste Welle (09) antreibbar ist, und die zweite Fingerkuppen-Kontaktfläche (21) der Drehscheibe bzw. des Drehrings (11), mit der die zweite Welle (10) antreibbar ist, auf der gleichen Höhe relativ zur Außenseite eines Gehäuses des Lichtstellpults (01) angeordnet sind, und wobei im Lichtstellpult (01) digitale Stellbefehle erzeugt werden, die über Datenverbindungen an die Beleuchtungseinrichtungen der Beleuchtungsanlage übertragen werden können, wobei das Lichtstellpult weiter zumindest einen Digitalprozessor und zumindest einen Digitalspeicher zur Erzeugung, Verwaltung und Speicherung der Stellbefehle umfasst.

2. Lichtstellpult nach Anspruch 1,
**dadurch gekennzeichnet,**
**dass** an der ersten Welle (09) ein erstes Rastwerk zur Verrastung unterschiedlicher Drehlagen der ersten Welle (09) vorgesehen ist, wobei der erste Drehsignalgeber zur Erzeugung eines ein Umschalten zwischen zwei Rastlagen anzeigenden Datensignals vorgesehen ist, und wobei an der zweiten Welle (10) ein zweites Rastwerk zur Verrastung unterschiedlicher Drehlagen der zweiten Welle (10) vorgesehen ist, und wobei der zweite Drehsignalgeber zur Erzeugung eines ein Umschalten zwischen zwei Rastlagen anzeigenden Datensignals vorgesehen ist.

3. Lichtstellpult nach einem der Ansprüche 1 bis 2,
**dadurch gekennzeichnet,**
**dass** zumindest eine Welle (10) zwischen einer Ruhestellung und einer Schaltstellung in Richtung ihrer Längsachse (13) axial verstellbar im Gehäuse (16) gelagert ist, wobei im Gehäuse (16) ein Schaltsensor (30) vorgesehen ist, mit dem die Ruhestellung und/oder Schaltstellung der axial verstellbaren Welle (10) detektierbar ist, wobei die Funktion eines Drehsignalgebers in Abhängigkeit von der Betätigung des Drucktasters umschaltbar ist.

4. Lichtstellpult nach einem der Ansprüche 1 bis 3,
**dadurch gekennzeichnet,**
**dass** unmittelbar benachbart zum Doppelwellenencoder (07) ein Drucktaster (25) angeordnet ist, wobei im Gehäuse (16) ein Schaltsensor vorgesehen ist, mit dem die Ruhestellung und/oder Schaltstellung des Drucktasters detektierbar ist.

5. Lichtstellpult nach einem der Ansprüche 1 bis 4,
**dadurch gekennzeichnet,**
**dass** das Lichtstellpult zumindest zwei Gehäuse umfasst, die mit einer Datenschnittstelle miteinander verbunden werden können, wobei am ersten Gehäuse der Doppelwellenencoder vorgesehen ist, und wobei das zweite Gehäuse den Digitalprozessor und zumindest einen Digitalspeicher zur Erzeugung, Verwaltung und Speicherung von Stellbefehlen umfasst.

6. Lichtstellpult nach Anspruch 5,
**dadurch gekennzeichnet,**
**dass** das zweite Gehäuse oder ein drittes Gehäuse, das mit dem zweiten Gehäuse mit einer Datenschnittstelle verbunden werden kann, die Anzeigeeinrichtung umfasst, und wobei an der Anzeigeeinrichtung Grafikelemente für den Benutzer grafisch dargestellt werden können.

7. Lichtstellpult nach Anspruch 6,
**dadurch gekennzeichnet,**
**dass** das zweite Gehäuse in der Art eines Laptops oder Personal Computers ausgebildet ist.

## Claims

1. A lighting control console (01) for controlling a lighting system, said lighting control console (01) comprising a control panel (08) and at least one display device, said display device being configured to graphically depict graphic elements for users, and at least one dual encoder (07) being provided in the control panel (08), which dual encoder allows users to enter input values, wherein the dual encoder (07) presents a first shaft (09) being mounted in a housing (16) so as to be rotatable, wherein a first rotation signal generator, for generating a data signal, is provided at the first shaft, wherein the dual encoder (07) presents a second shaft (10) being mounted in the housing (16) so as to be coaxially rotatable, wherein a second rotation signal generator for generating a data signal is provided at the second shaft (10), wherein both shafts (09, 10) present actuating elements (11, 12), at which adjusting movements are transmitted onto the shafts (09, 10) by hand, and wherein the actuating elements, for hand-actuated adjustment of the shafts (09, 10), are in each case embodied in the manner of a rotary disk (12) or of a rotary swivel (11) disposed in the control panel (08) of the lighting control console (01) and configured to be coaxially turned in opposite directions,
**characterised in that**
the upper side of the rotary disk (12) or of the rotary swivel (11) is embodied in the manner of a fingertip contact surface (21, 22), wherein the respective rotary disk (12) or the respective rotary swivel (11) is rotationally driven by way of the engagement of a fingertip at the fingertip contact surface (21, 22), wherein the fingertip contact surface (21, 22) is concave in each case, wherein the fingertip contact surface (21) in each case presents an annular shape or a circular shape, wherein the first fingertip contact surface (22) of the rotary disk (12) or of the rotary swivel, with the aid of which the first shaft (09) is driven, and the second fingertip contact surface (21) of the rotary disk or of the rotary swivel (11), with the aid of which the second shaft (10) is driven, are disposed on the same level in relation to the outside of a housing of the lighting control console (01), and wherein digital adjusting commands are generated in the lighting control console (01), which commands are transmitted to the lighting devices of the lighting system via data links, wherein said lighting control console further comprises at least one digital processor and at least one digital memory for generating, managing and storing the adjusting commands.

2. The lighting control console according to claim 1,
**characterised in that**
a first locking mechanism, for locking different rotational positions of the first shaft (09), is provided at the first shaft (09), wherein the first rotation signal generator is provided for generating a data signal showing a switchover between two locking positions, and wherein a second locking mechanism for locking different rotational positions of the second shaft (10) is provided at the second shaft (10), and wherein the second rotation signal generator is provided for generating a data signal showing a switchover between two locking positions.

3. The lighting control console according to any one of the claims 1 to 2,
**characterised in that**
at least one shaft (10) is mounted in the housing (16) so as to be axially adjustable in the direction of its longitudinal axis (13) between a rest position and a switched position, wherein a switching sensor (30) is provided in the housing (16), with the aid of which sensor the rest position and/or the switched position of the axially adjustable shaft (10) are/is detected, wherein the function of a rotation signal generator is switched as a function of the actuation of the push button.

4. The lighting control console according to any one of the claims 1 to 3,
**characterised in that**
a push button (25) is disposed directly next to the dual encoder (07), wherein a switching sensor is provided in the housing (16), with the aid of which sensor the rest position and/or the switched position of the push button are/is detected.

5. The lighting control console according to any one of the claims 1 to 4,
**characterised in that**
the lighting control console comprises at least two housings that are linked to each other with the aid of a data interface, wherein the dual encoder is provided at the first housing, and wherein the second housing comprises the digital processor and at least one digital memory for generating, managing and storing adjusting commands.

6. The lighting control console according to claim 5,
**characterised in that**
the second housing or a third housing that is linked to the second housing with the aid of a data interface comprises the display device, and wherein graphic elements are graphically depicted for users at the display device.

7. The lighting control console according to claim 6,
**characterised in that**
the second housing is embodied in the manner of a laptop or of a personal computer.

## Revendications

1. Pupitre de commande d'éclairage (01) pour commander un système d'éclairage, ledit pupitre de commande d'éclairage (01) comprenant un panneau de commande (08) et au moins un dispositif d'affichage, des éléments graphiques pouvant être visualisés graphiquement pour l'utilisateur audit dispositif d'affichage, et au moins un encodeur à deux arbres (07) étant prévu dans le panneau de commande (08), des utilisateurs pouvant entrer des valeurs d'entrée audit encodeur à deux arbres, ledit encodeur à deux arbres (07) présentant un premier arbre (09) monté dans un boîtier (16) de façon rotative, un premier générateur de signaux de rotation, pour générer un signal de données, étant prévu au premier arbre, ledit encodeur à deux arbres (07) présentant un deuxième arbre (10) monté dans le boîtier (16) à rotation coaxiale, un deuxième générateur de signaux de rotation pour générer un signal de données étant prévu au deuxième arbre (10), les deux arbres (09, 10) présentant des éléments d'actionnement (11, 12) auxquels des mouvements de réglage peuvent être transmis aux arbres (09, 10) à la main, et lesdits éléments d'actionnement, pour le réglage manuel des arbres (09, 10), respectivement étant réalisés à la manière d'un disque rotatif (12) ou d'une bague rotative (11) qui sont disposés dans le panneau de commande (08) du pupitre de commande d'éclairage (01) et qui peuvent être tordus coaxialement l'un contre l'autre,
**caractérisé en ce que**
le(s) côté(s) supérieur(s) du disque rotatif (12) et/ou de la bague rotative (11) est/sont réalisé(s) à la manière d'une surface de contact de bout du doigt (21, 22), ledit disque rotatif (12) respectif et/ou ladite bague rotative (11) respective pouvant être entraînés/ entraîné(e) de façon rotative moyennant l'engagement d'un bout du doigt à la surface de contact de bout du doigt (21, 22), chacune desdites surfaces de contact de bout du doigt (21, 22) étant voûtée de façon concave, ladite surface de contact de bout du doigt (21) présentant une forme annulaire ou une forme circulaire respectivement, ladite première surface de contact de bout du doigt (22) du disque rotatif (12) et/ou de la bague rotative (11), à l'aide de laquelle le premier arbre (09) peut être entraîné, et ladite deuxième surface de contact de bout du doigt (21) du disque rotatif et/ou de la bague rotative (11), à l'aide de laquelle le deuxième arbre (10) peut être entraîné, étant disposées au même niveau par rapport au côté extérieur d'un boîtier du pupitre de commande d'éclairage (01),
et des instructions de réglage numériques qui peuvent être transmises aux dispositifs d'éclairage du système d'éclairage par des liaisons de données étant générées dans ledit pupitre de commande d'éclairage (01), ledit pupitre de commande d'éclairage de plus comprenant au moins un processeur numérique et au moins une mémoire numérique pour générer, gérer et stocker les instructions de réglage.

2. Pupitre de commande d'éclairage selon la revendication 1,
**caractérisé en ce**
**qu'**un premier mécanisme de verrouillage, assurant le verrouillage de positions de rotation différentes du premier arbre (09), est prévu au premier arbre (09), le premier générateur de signaux de rotation étant prévu pour générer un signal de données indiquant une commutation entre deux positions de verrouillage, et un deuxième mécanisme de verrouillage, assurant le verrouillage de positions de rotation différentes du deuxième arbre (10), étant prévu au deuxième arbre (10), et le deuxième générateur de signaux de rotation étant prévu pour générer un signal de données indiquant une commutation entre deux positions de verrouillage.

3. Pupitre de commande d'éclairage selon l'une quelconque des revendications 1 à 2,
**caractérisé en ce**
**qu'**au moins un arbre (10) est monté dans le boîtier (16) de manière axialement ajustable dans la direction de son axe longitudinal (13) entre une position normale et une position de commande, un capteur de commande (30) étant prévu dans le boîtier (16) à l'aide duquel la position normale et/ou la position de commande de l'arbre (10) qui est axialement ajustable peuvent/peut être détectée(s), la fonction d'un générateur de signaux de rotation pouvant être commutée en fonction de l'actionnement du bouton-poussoir.

4. Pupitre de commande d'éclairage selon l'une quelconque des revendications 1 à 3,
**caractérisé en ce**
**qu'**un bouton-poussoir (25) est disposé de façon à être immédiatement voisin de l'encodeur á deux arbres (07), un capteur de commande étant prévu dans le boîtier (16) à l'aide duquel la position normale et/ou la position de commande du bouton-poussoir peuvent/peut être détectée(s).

5. Pupitre de commande d'éclairage selon l'une quelconque des revendications 1 à 4,
**caractérisé en ce que**
le pupitre de commande d'éclairage comprend au moins deux boîtiers qui sont configurés pour être reliés entre eux à l'aide d'une interface de données, ledit encodeur à deux arbres étant prévu au premier boîtier, et ledit deuxième boîtier comprenant le processor numérique et au moins une mémoire numérique pour générer, gérer et stocker des instructions de réglage.

6. Pupitre de commande d'éclairage selon la revendication 5,
**caractérisé en ce que**
le deuxième boîtier ou un troisième boîtier qui peut être relié avec le deuxième boîtier à l'aide d'une interface de données comprend le dispositif d'affichage, et des éléments graphiques pouvant être visualisés graphiquement pour l'utilisateur audit dispositif d'affichage.

7. Pupitre de commande d'éclairage selon la revendication 6,
**caractérisé en ce que**
le deuxième boîtier est réalisé à la manière d'un ordinateur portable ou d'ordinateur individuel.
